Europäisches Patentamt

European Patent Office

Office européen des brevets

(19)

(11) EP 1 118 866 A1

(12) **EUROPEAN PATENT APPLICATION**

(43) Date of publication:
25.07.2001 Bulletin 2001/30

(51) Int Cl.[7]: **G01R 29/26**, G01R 13/34

(21) Application number: 01300348.8

(22) Date of filing: 16.01.2001

| (84) Designated Contracting States: | (72) Inventors: |
|---|---|
| AT BE CH CY DE DK ES FI FR GB GR IE IT LI LU MC NL PT SE TR | • Onu, Dan Beaverton, Oregon 97007 (US) |
| Designated Extension States: AL LT LV MK RO SI | • Pepper, Steven H. Portland, Oregon 97229 (US) |
| (30) Priority: 20.01.2000 US 177750 P | (74) Representative: Burke, Steven David et al R.G.C. Jenkins & Co. |
| (71) Applicant: Tektronix, Inc. Beaverton, OR 97077-0001 (US) | 26 Caxton Street London SW1H 0RJ (GB) |

(54) **Method of estimating phase noise spectral density and jitter in a periodic signal**

(57) A method of estimating phase noise spectral density from a jitter versus time vector array obtained from a periodic signal having an average frequency includes the an initial step of converting the jitter verus time vector array to a phase error versus time vector array using an estimate of the average frequency of the periodic signal. A time to frequency transform is applied to the phase error versus time vector array to generate a phase error magnitude versus frequency vector array, and a phase noise spectral density vector array obtained by normalizing the phase error magnitude versus time vector array to a one hertz bandwidth. The method of estimating the jitter in the periodic signal includes the steps of generating a vector array of estimated reference crossing times of the periodic signal in the waveform record using interpolation and calculating an estimated periodic signal frequency based on a selected number of reference crossings in the estimated reference crossing times vector array and associated time positions of the waveform samples from the first selected reference crossing to the last selected reference crossing in the waveform record. A vector array of uniformly spaced ideal reference crossing times is generated based on the estimated periodic signal frequency, and a uniformly spaced jitter versus time vector array is generated by determining the difference between the ideal reference crossing times and the corresponding estimated reference crossing times of the periodic signal.

FIGURE 1

# EP 1 118 866 A1

## Description

### CROSS-REFERENCE TO RELATED APPLICATION

This application claims the benefit of the U.S. Provisional Application No. 60/177,750 filed January 20, 2000.

### BACKGROUND OF THE INVENTION

The present invention related generally to the measurement of phase noise spectral density and jitter in a periodic signal and more particularly to the measurement of phase noise spectral density and jitter in a digitally sampled waveform record acquired in the time domain.

Jitter is the time deviation of a periodic signal's "significant instants" from an ideal non-jittered periodic signal. The periodic signal may be an electrical or optical modulated or unmodulated carrier signal. Phase noise spectral density is the spectral density of unwanted phase modulation or jitter on the fundamental frequency of a periodic signal. The amount of jitter and phase noise in a periodic signal is an important measurement parameter for circuit and system designers. There are a number of measurement instruments and methods for measuring the jitter and phase noise. A spectrum analyzer measures the magnitude of a signal under test in the frequency domain. One drawback to using a spectrum analyzer to measure phase noise is that the instrument cannot distinguish between amplitude modulation noise and phase modulation noise. Additionally, conventional spectrum analyzers require a separate calibration procedure to relate voltage or power to phase. It also has a small analysis frequency span around the carrier signal and the spectrum is not normalized to dB/carrier (dBc/Hz).

Another system for measuring the phase error is a hardware implemented analog system having an accurate reference oscillator that outputs a periodic signal with the same frequency as the periodic signal being measured. The output of the oscillator is coupled to a multiplier circuit that receives the signal under test containing phase noise. The output of the multiplier is an signal having two components, the sum and difference of the reference oscillator output and the signal under test. The output of the multiplier is passed through a low pass filter to remove the high frequency components which leaves the phase noise of the signal under test. A drawback to this type of system is the requirement for the reference oscillator to have a stable and precise output. This would require a very precisely controlled phase locked loop (PLL). There would then be a need to correct the measured data for the PLL response for the offset frequencies less than the lock bandwidth.

A further system employs a heterodyne/ counter method. A counter is triggered on a rising or falling edge of the periodic signal under test crossing a threshold value and incremented by an internal clock. On the next rising or falling edge crossing the threshold, the counter is stopped and the period of the internal lock times the count on the counter. On a subsequent rising or falling edge, the counter is again initiated and a count is acquired to the next rising or falling edge. One drawback to this type of system is that the results represent period disturbance. In addition, the system does not have a reference clock equal to the average frequency of the periodic signal under test. Further, the system does not produce uniformly space time intervals for the measured periods which is a necessity for accurate transform from the time domain to the frequency domain. Additionally, the system does not measure the time between each rising edge since each second edge is used to disable the counter.

Digital oscilloscopes have also been used to measure the jitter of a signal under test in the time domain. An acquisition system acquires a waveform record of the signal under test. An average period of the signal under test is generated from the waveform record to produce an ideal clock. A reference crossing point is defined for the signal under test and the ideal clock. The magnitude difference between the reference crossings of the signal under test and reference crossings of the ideal clock are computed to produce magnitude phase error values relative to the signal under test. The magnitude phase error values need to be resampled at an interpolated sample rate to generate an equally spaced sample interval that is applied to a time to frequency transform to generate a magnitude versus frequency output of the magnitude phase error values. A drawback to the above described method is the need to resample the error data at an interpolated sample rate to generate uniformly space phase error values. Further, the signal under test may contain amplitude noise and additive noise from the measurement instrument in addition to phase noise. Such instrument generated noise cannot be separated from the phase noise and will be transformed as part of the phase noise spectral density.

What is needed is an improved method for measuring the phase noise spectral density of a periodic signal that does not require the interpolated resampling of the error values to produce uniformly spaced error values. Additionally, the improved method should provide a new method of determining the jitter in the periodic signal that is not dependent on measured magnitude values.

## SUMMARY OF THE INVENTION

Accordingly, the present invention is a method of estimating phase noise spectral density and jitter in a periodic signal acquired in a digitally sampled waveform record in the time domain. The present invention estimates the phase noise spectral density and jitter by relying on timing information of events in the digitally sampled waveform record. One aspect of the invention is estimating the jitter in the periodic signal that includes the step of generating a vector array of estimated reference crossing times of the periodic signal in the waveform record using interpolation. An estimate of the periodic signal frequency is calculated based on a selected number of reference crossings in the estimated reference crossing times vector array and associated time positions of the waveform samples from the first selected reference crossing to the last selected reference crossing in the waveform record. A vector array of uniformly spaced ideal reference crossing times is generated based on the estimated periodic signal frequency, and a uniformly spaced jitter versus time vector array is generated by determining the difference between the ideal reference crossing times and the corresponding estimated reference crossing times of the periodic signal.

A further aspect of the invention is estimating phase noise spectral density from the jitter versus time vector array that includes the step of converting the jitter verus time vector array to a phase error versus time vector array using an estimate of the average frequency of the periodic signal in radians per second. A time to frequency transform is applied to the phase error versus time vector array to generate a phase error magnitude versus frequency vector array, and a phase noise spectral density vector array is obtained by normalizing the phase error magnitude versus time vector array to a one hertz bandwidth. A frequency band may be defined in the phase noise spectral density vector array, and the phase noise values in the phase noise spectral density vector array within the defined frequency band are integrated to obtain a jitter RMS value within the defined frequency band.

The generation of the estimated reference crossing times vector array step further includes the alternative steps of either estimating rising edge reference crossing times of the periodic signal in the waveform record or falling edge reference crossing times of the periodic signal in the waveform record. A further alternative step includes concurrently generating a vector array of estimated rising reference crossing times of the periodic signal in the waveform record using interpolation and a vector array of estimated falling reference crossing times of the periodic signal in the waveform record using interpolation. From the rising and falling reference crossing times vector arrays a vector array of estimated pulse width deviation times is generated by comparing the estimated rising reference crossing times vector array to the estimated falling reference crossing times vector array.

The interpolation to generated the estimated reference crossing times may be implemented by linearly interpolating between the first data sample above the reference crossing and the first data sample below the reference crossing. Alternately, the interpolating step may be implemented by generating a higher order interpolator using multiple digital data samples above and below the reference crossing where the higher order interpolator step includes the step of generating a window, such as a sin(x)/x function.

The calculating of the estimated periodic signal frequency includes the step of interpolating an average slope from the number of reference crossing times and the sum of the reference crossing times where the interpolation step includes calculating a best fit linear curve to the respective number of reference crossing times and the corresponding reference crossing times, and estimating the periodic signal frequency from the slope of the fitted line.

The objects, advantages and novel features of the present invention are apparent from the following detailed description when read in conjunction with appended claims and attached drawings.

## BRIEF DESCRIPTION OF THE DRAWING FIGURES

Figure 1 is a representative block diagram of a time domain measurement system implementing the method of estimating the phase noise spectral density and jitter in a periodic signal according to the present invention.

Figure 2 is a representative waveform trace of a periodic signal having phase errors.

Figure 3 is an enlarged view of a rising edge of the periodic signal crossing a reference level illustrating the interpolation of the crossing point time of the rising edge.

Figure 4 is a graphical representation for estimating the frequency of the periodic signal.

Figure 5 is a graphical representation of the generated uniformly spaced ideal reference crossings from the estimated periodic signal frequency and the jitter between the ideal reference crossings and the estimated reference crossings of the periodic signal.

Figures 6 is a graphical representation of the jitter versus time of the uniformly spaced ideal reference crossings.

Figures 7A and &B are a flow chart showing the steps in estimating the phase noise spectral density and jitter in a periodic signal according to the present invention.

DETAILED DESCRIPTION OF THE PREFERRED EMBODIMENT

In the following detailed description numerous specific details are set forth in order to provide a thorough understanding of the present invention. However, it will be understood by those skilled in the art that the present invention may be practiced without these specific details. In other instances well known methods, procedures, components, and circuits have not been described in detail so as not to obscure the present invention.

Part of the description will be presented in terms of operations performed by a measurement instrument, using terms such as data, values, signal samples, numbers and the like, consistent with the manner commonly employed by those skilled in the art to convey the substance of their work to others skilled in the art. As is well understood by those skilled in the art, these quantities take the form of electrical, magnetic, or optical signals capable of being stored, transferred, combined and otherwise manipulated through mechanical and electrical components of the measurement instrument; and the term measurement instrument includes general purpose as well as special purpose data processing machines, systems, and the like, that are stand alone, adjunct or embedded.

Additionally, various operations will be described as multiple discrete steps in turn in a manner that is most helpful in understanding the present invention, however, the order of description should not be construed as to imply that these operations are necessarily order dependent, in particular, the order of their presentation.

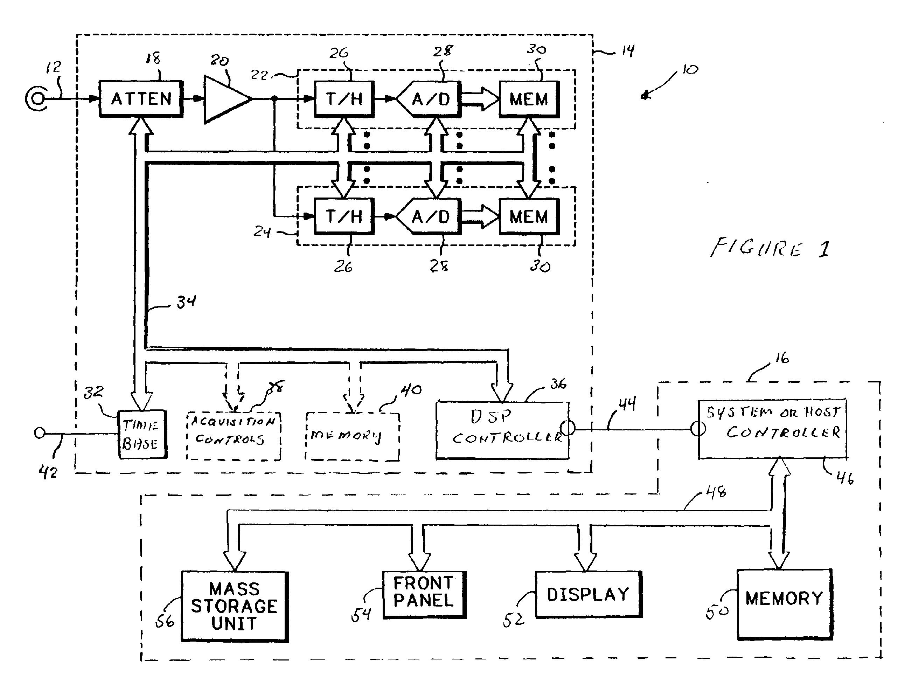

Referring to Figure 1, there is shown a representative block diagram of a digital sampling system 10 that acquires a waveform record of an input periodic signal under test 12. The measurement system may be a digital oscilloscope having an acquisition subsystem, representatively shown at 14, and an instrument control subsystem 16. Alternately, the acquisition subsystem 14 may be a separate digitizing unit with the instrument control subsystem 16 being a host computer that receives acquired waveform data from the digitizer. The input periodic signal 12 is coupled through a variable attenuator 18 and a preamplifier 20. In high digitizing rate sampling oscilloscopes, such as the TDS7104 Digital Oscilloscope, manufactured and sold by Tektronix, Inc. Beaverton, Oregon and assignee of the instant invention, each input channel has digitizing pipes, as representatively shown as pipes 22 and 24. Any number of pipes may be included for each oscilloscope input channel. Each pipe has a track-and-hold (T/H) circuit 26, an analog-to-digital (A/D) converter 28 and a memory 30. A time base 32 provides timing signals to the acquisition subsystem 14 for latching an analog value of the input signal in the T/H circuits 26, clocking the A/D converters 28 to digitize the analog value on the T/H circuit and storing the digitized values in memories 30. The pipes 22, 24 have additional circuitry (not shown) that offsets or delays the time base signals for each pipe 22, 24 to produce an acquisition rate "X" times the timing signal rate where "X" is the number of pipes in the acquisition subsystem 14.

The time base 32 is coupled to a control and address bus 34 for receiving commands from a DSP controller 36. The DSP controller may be an application specific integrated circuit (ASIC) or a microprocessor, such as a Intel CELERON™ microprocessor, manufactured and sold by Intel, Corp., Santa Clara, CA. Also coupled to the control and address bus is the variable attenuator 18 and the circuitry within the digitizing pipes 22, 24. The acquisition subsystem 14 may also include acquisition controls 38 and memory 40 when the subsystem 14 is a separate digitizing unit. The acquisition controls 38 may include buttons, rotatable knobs and the like and/or control entry devices, such as a keyboard and/or mouse, for setting the time base and acquisition parameters for the digitizing unit. The memory 40 contains stored program instructions that are accessed by the DSP controller 36 for controlling the operation of the acquisition subsystem 14. When the acquisition subsystem 14 is part of a digital oscilloscope, the acquisition controls 38 and memory 40 are incorporated into the front panel and system memory of the oscilloscope. An external reference line 42 is coupled to the time base 32 that allows the time base to be locked to an external reference source.

The acquisition subsystem 14 is coupled to the instrument control subsystem 16 via an interface bus 44. The interface bus 44 provided bi-directional communications for transferring data and control signal between the subsystems. The interface bus 44 may be a commercially available bus adapter integrated circuit that controls the transfer of data between two bus systems. The interface bus may also be a bidirectional serial bus, such as an internal $I^2C$ bus for an oscilloscope or an external GPIB bus for a digitizing unit and a computer. The instrument control subsystem 16 includes a system or host controller 46, coupled via system bus 48 to system memory 50, a display device 52, front panel controls 54, and a mass storage unit 56. The system memory 50 includes both RAM, ROM and cache memory with the RAM memory storing volatile data, such as the data values representative of the input signal passed by the acquisition subsystem 14. The controller 46 is preferably a microprocessor, such as PENTIUM® microprocessor, manufactured and sold by Intel, Corp., Santa Clara, CA. The display device 52 may be a liquid crystal display, cathode ray tube or the like, and front panel controls 54 may include buttons, rotatable knobs and the like and/or control entry devices, such as a keyboard and/or mouse. The mass storage unit or units 56 may be a hard disk drive, a CD ROM drive, a tape drive, a floppy drive or the like, that reads from and/or writes to appropriate mass storage media. The digital sampling phase error measurement system 10 in the preferred embodiment of the invention is a PC based system controlled under WINDOWS® 98 operating system, manufactured and sold by Microsoft, Corp., Redmond, WA.

The present invention has the distinct advantage of estimating the phase noise spectral density and jitter by relying on timing information of events in the digitally sampled waveform record. Additionally, the present invention is a computationally efficient of producing uniformly spaced jitter and phase noise spectral density data using the time data of the digitally acquired waveform record.

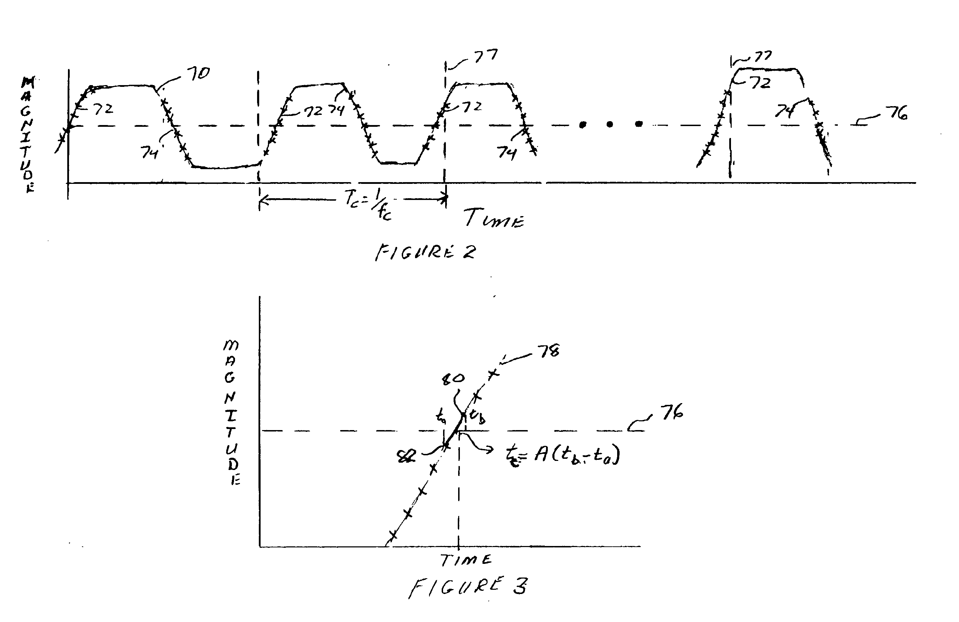

The below description of the method of estimating the phase noise spectral density and jitter in a digitally acquired waveform record of a periodic signal will be described with reference to Figures 2 through 7. Referring to representative waveform trace of Figures 2, the is shown a periodic signal 70 having rising and falling edges 72 and 74 representing a clipped sinusoidal signal. The clipped sinusoidal signal is for illustrative purposed only and any type of periodic signal may be used in the below described method. Also for illustration purposes, the periodic signal is shown with a DC level. The periodic signal is referenced to a reference level, labeled 76, which may or may set to zero volts providing the periodic waveform is not at a DC level. The periodic signal 70 is sampled at a uniform sample rate by the acquisition subsystem 14 as represented by the "x"s on the waveform trace. The vertical dashed lines 77 represent the reference crossings of the periodic signal 70 without jitter. In the preferred embodiment, the acquisition subsystem 14 can sample the periodic signal at up to a 20 Gsamples/sec rate. That would allow a 100 MHZ periodic signal to be sampled 200 times per period. Usually, the reference level 76 will fall between two successive waveform samples on the rising or falling edges of the periodic signal requiring interpolation to estimate the crossing point of the edge relative to the reference level.

Figure 3 shows an enlarged view of a periodic signal edge 78 crossing the reference level 76. As can be seen in the figure, there is no waveform sample at the reference level. The simplest form of interpolation is linear interpolation of at least a first data sample 80 above the reference crossing point and a first data sample 82 below the reference crossing point. The time difference between the data sample above the reference and the data sample below the reference level is calculated. A weighting factor "A" derived from the slope of the line between the data samples above and below the reference level is applied to the calculated time difference and the resulting time value is the estimated time of the reference level crossing of the periodic signal edge Higher order interpolation may be used for determining the time of the reference crossing point, such as a windowed sin(x)/x function using multiple samples above and below the reference crossing point.

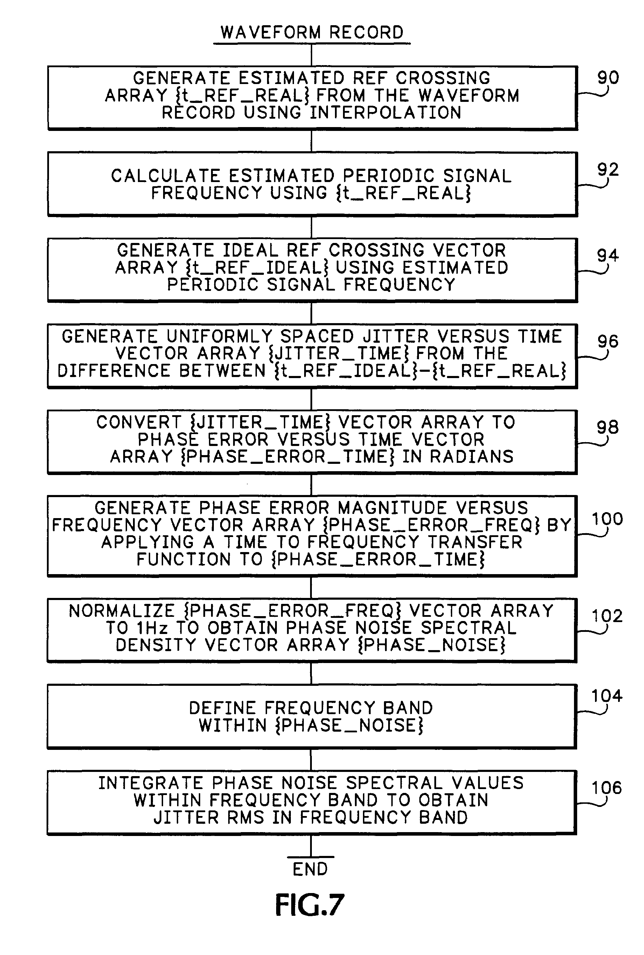

The interpolated reference crossing times of the periodic signal edges $\{t_1{}^{real}, ..., t_n{}^{real}\}$ are stored in a vector array called *t_ref_real* as represent in box 90 in Figure 7A.

$$t\_ref\_real = \{t_1{}^{real}, t_2{}^{real}, t_3{}^{real}, ... \; t_n{}^{real}\} \tag{1}$$

The *t_ref_real* vector array may be composed of either the reference crossing times of the rising edges of the period signal or the falling edges of the periodic signal. It is also possible to estimate the reference crossing levels for both the rising and falling edges of the periodic signal and concurrently generate estimated reference crossing times vector arrays for the rising edges *t_rise_ref_real* and the falling edges *t_fall_ref_real.*

$$t\_rise\_ref\_real = \{t_{rise,1}^{real}, t_{rise,2}^{real}, t_{rise.3}^{real}, ... \; t_{rise,n}^{real}\} \tag{2}$$

$$t\_fall\_ref\_real = \{t_{fall,1}^{real}, t_{fall,2}^{real}, t_{fall,3}^{real}, ... \; t_{fall,n}^{real}\} \tag{3}$$

A pulsewidth deviation vector array *t_pw_dev* can be generate by comparing the rising edge reference crossing vector array *t_rise_ref_real* in relation to the falling edge reference crossing vector array *t_fall_ref_real.*

$$t\_pw\_dev = \{t_1^{pw\_dev}, t_2^{pw\_dev}, t_3^{pw\_dev}, ... \; t_n^{pw\_dev}\} \tag{4}$$

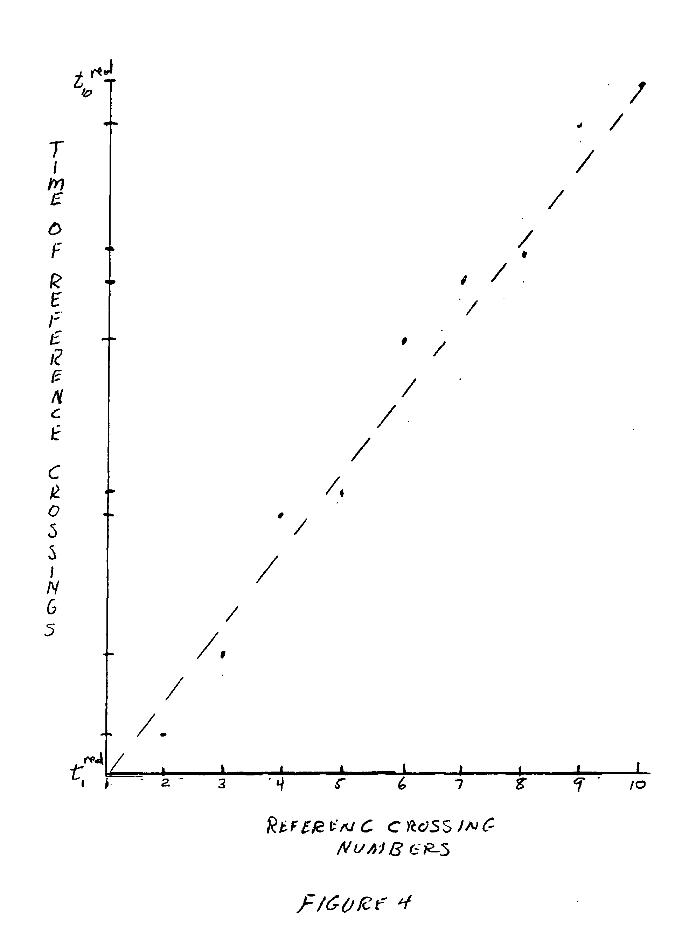

The method of estimating the periodic signal frequency from the *t_ref_real* vector array is best understood with reference to Figure 4. The frequency of the periodic signal is estimated using the reference crossings in the *t_ref_real* reference crossing vector array. If the *t_ref_real* reference crossing vector array is large indicating a large waveform record, a smaller number of reference crossing may be used so long as a sufficient number of reference crossings are selected to provide a statistically significant representation of the periodic signal period. The horizontal axis is scaled in reference crossing numbers and the vertical scaled in time. The reference level crossing times are plotted to the respective crossing number using a linear scale on both axes. As shown in the figure, the plot of the reference level crossing times reveals an approximate linear curve that represents the frequency of the periodic signal. A best fit linear curve is generated for the *t_ref_real* vector array and the slope of the fitted line is the estimate of the periodic signal frequency. The linear curve may be generated by taking the number of periods in the selected time interval and dividing by the time difference between the reference level crossing at $t_n$ and $t_1$ as represented by box 92 in Figure 7A and the following equation.

$$f_c = \frac{1}{T_c} = \frac{(n - 1)}{(t_n^{real} - t_1^{real})} \qquad (5)$$

The calculated frequency of the periodic signal $f_c$ is used to generate a vector array of uniformly spaced ideal reference crossing points $t\_ref\_ideal$ of the periodic signal. The initial reference crossing point $t_1^{real}$ of the periodic signal is used as the initial ideal crossing point. The vector array $t\_ref\_ideal$ contains the ideal time series that would correspond to phase error free uniformly spaced reference crossing as represented box 94 in Figure 7A and the below vector sequence.

$$t\_ref\_ideal = \{t_1^{ideal}, t_1^{ideal} + \frac{1}{f_c}, t_1^{ideal} + \frac{2}{f_c}, t_1^{ideal} + \frac{3}{f_c}, \dots t_1^{ideal} + \frac{(n-1)}{f_c}\} \qquad (6)$$

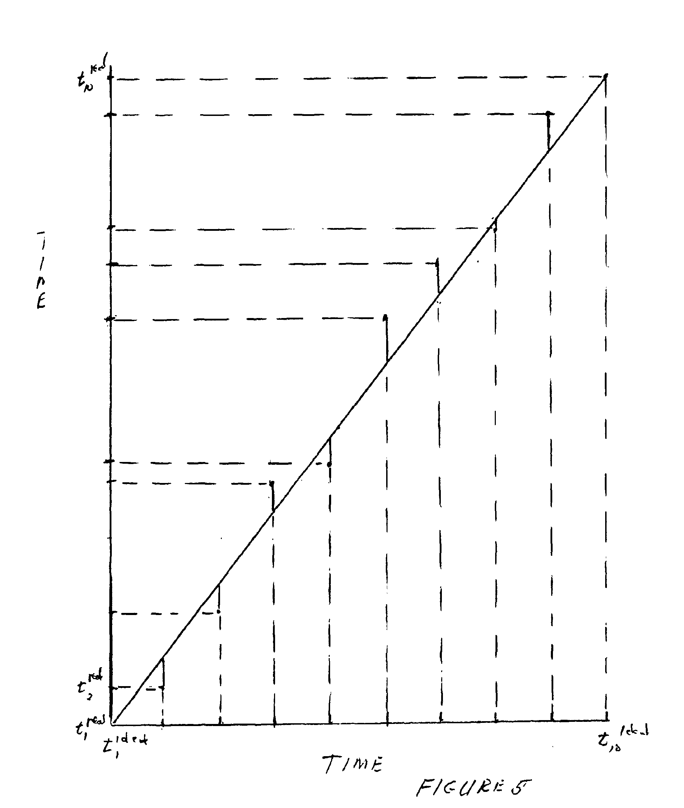

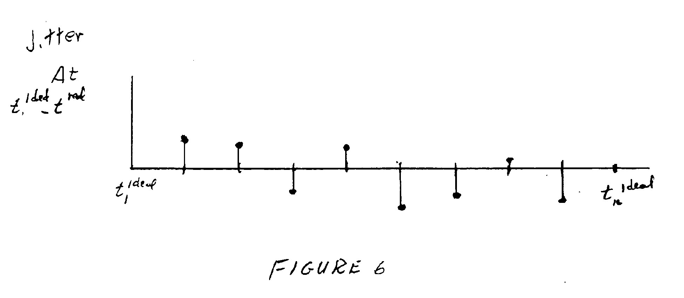

Figures 5 and 6 graphically show the generation of a uniformly spaced jitter versus time $jitter\_time$ vector array. Both the horizontal and vertical axis are scaled in time with the horizontal axis divided into uniformly space ideal reference crossing point from the $t\_ref\_ideal$ vector array. The reference crossing times from the $t\_ref\_real$ reference crossing vector array are plotted on the vertical axis. The diagonal line represents the frequency of the periodic signal. $t_1^{ideal}$ is obtained as the time position or coordinate of the intersection of the estimated ideal frequency with the horizontal axis in Figure 5. The difference between the intersections of the $t^{ideal}$ times and the corresponding $t^{real}$ times and the reference frequency line is the jitter. The $jitter\_time$ vector array is uniformly spaced on the $t^{ideal}$ times. The $jitter\_time$ vector array in the generated by subtracting on an element by element basis the periodic signal real reference crossing points from the corresponding ideal reference crossing points are represented by box 96 in Figure 7A and below vector sequence.

$$jitter\_time = \{t_1^{ideal} - t_1^{real}, t_2^{ideal} - t_2^{real}, t_3^{ideal} - t_3^{real}, \dots t_n^{ideal} - t_n^{real}\} \qquad (7)$$

The $jitter\_time$ vector array is converted to a phase error versus time vector array $phase\_error\_time$ by multiplying the elements of the $jitter\_time$ vector array by the periodic signal frequency in radians per second as represented by box 98 in Figure 7A and the below vector sequence.

$$phase\_error\_time = \{\varphi_1(t_1^{ideal}), \dots \varphi_n(t_n^{ideal})\} \qquad (8)$$

where $\varphi_i = \varphi\ (t_i^{ideal})$, $i, \bar{n}$ . The significance of the $phase\_error\_time$ vector array is that it was uniformly spaced in time and generated from $jitter\_time$ vector array that is scaled in time and not in voltage magnitude. Having an uniformly spaced $phase\_error\_time$ vector array allows the generation of an accurate frequency domain spectral density vector array $spectral\_phase\_noise$ from the $phase\_error\_time$ vector array. A time to frequency transform, such as a Fast Fourier Transform function, is applied to the $phase\_error\_time$ vector array to generate a phase error magnitude versus frequency vector array $phase\_error\_freq$ as represented by box 100 in Figure 7A and the below vector sequence:

$$phase\_error\_freq = \{\varphi(F_i), \dots \varphi(F_{\frac{n}{2}})\} \qquad (9)$$

where $F_i = (i - 1) \times F_c / 2$. There are a number of time to frequency transforms that can convert a time domain sequence to the frequency domain sequence and the method of the present invention is not limited to any one particular transform.
The $phase\_error\_freq$ vector array is normalized to the to a 1 Hz bandwidth to generate a spectral density phase noise vector array $spectral\_phase\_noise_i$ as represented by box 102 in Figure 7A and the below vector sequences

$$spectral\_phase\_noise_i = \{\varphi F_i \times \frac{(n-1)}{2T_c}\} \qquad (10)$$

where *i* denotes frequency components in vector sequence (9) that are not deterministic (i.e. a pure tone).

$$spectral\_phase\_noise_i = \{\varphi F_i\}i \qquad (11)$$

where *i* denotes deterministic frequency components in vector sequence (9) (i.e. discrete frequency components). Those skilled in the art might employ different methods for identifying discrete frequency components in vector sequence (9). One such method would sub-sample the *phase_error_time* vector array, re-compute the *spectral_phase_noise* vector array using only the formula in vector sequence (10) and identifying frequency components in the *spectral_phase_noise* vector array which remain constant as discrete components.

Jitter RMS may be obtained within a frequency band of phase noise spectral density vector array by using a filter function to define a frequency band within the *spectral_phase_noise* vector array as represented by box 104 in Figure 7B and performing a numerical integration on the filtered phase noise values over the defined frequency band as represented by box 106 in Figure 7B. Numerical integration can also be performed on the all the elements in the *spectral_phase_noise* vector array to obtain the total jitter RMS of the periodic signal.

A method has been described for estimating phase noise spectral density and jitter in a digitally sampled periodic signal. The method includes the steps of generating a vector array of the estimated reference crossing times of the periodic signal in the waveform record and calculating an estimated periodic signal frequency based on a estimated reference crossing time of the periodic signal. The estimated periodic signal frequency is used to generate a vector array of uniformly spaced ideal crossing times. A uniformly spaced vector array of jitter versus time is generated by determining the difference between the ideal crossing times and the corresponding estimated reference crossing times of the periodic signal. The jitter versus time vector array is converted to a phase error versus time vector array by multiplying the element of the vector array by the frequency of the periodic signal in radians per second. A phase error magnitude versus frequency vector array is generated by applying a time to frequency transform function to the phase error versus time vector array. The phase error magnitude versus frequency vector array is normalized to a one hertz bandwidth to produce a phase nosie spectral density vector array. Numerical integration may be performed on all or a portion of the phase noise spectral density vector array to generate RMS jitter values for the periodic signal or a frequency band within the phase noise spectral density vector array.

It will be obvious to those having skill in the art that many changes may be made to the details of the above-described embodiments of this invention without departing from the underlying principles thereof. For example, the digital sampling system may be synchronously sample the periodic signal under test by locking the time base to an external reference source having a frequency equal to the periodic signal under test. A vector array of voltage versus estimated reference crossing times may then be generated the waveform record and a jitter versus time vector array generated by dividing the voltage versus time array by the slope of the periodic signal in the vicinity of the crossings. The scope of the present invention should, therefore, be determined only by the following claims.

## Claims

1. A method of estimating phase noise spectral density from a jitter versus time vector array obtained from a periodic signal having an average frequency comprising the steps of:

   a) converting the jitter versus time vector array to a phase error versus time vector array using an estimate of the average frequency of the periodic signal;
   b) applying a time to frequency transform to the phase error versus time vector array to generate a phase error magnitude versus frequency vector array; and
   c) obtaining a phase noise spectral density vector array by normalizing the random phase error magnitude component of the phase error magnitude versus frequency vector array to a one hertz bandwidth.

2. The method of estimating phase noise spectral density as recited in claim 1 further comprising the steps of:

   a) using a filter function to define a frequency band in the phase noise spectral density vector array; and
   b) integrating the filtered phase noise values in the phase noise spectral density vector array over the defined frequency band to obtain a jitter RMS value within the define frequency band.

3. The method of estimating phase noise spectral density as recited in claim 1 wherein the converting step further comprises the step of multiplying the jitter versus time vector array by average frequency of the periodic signal in radians per second.

4. A method of estimating phase noise spectral density in a periodic signal acquired in a digitally sampled waveform record comprising the steps of:

a) generating a vector array of estimated reference crossing times of the periodic signal in the waveform record using interpolation;
b) calculating an estimated periodic signal frequency based on a selected number of reference crossings in the estimated reference crossing times vector array and associated time positions of the waveform samples from the first selected reference crossing to the last selected reference crossing in the waveform record;
c) generating a vector array of uniformly spaced ideal reference crossing times based on the estimated periodic signal frequency;
d) generating a uniformly spaced jitter versus time vector array by determining the difference between the ideal reference crossing times and the corresponding estimated reference crossing times of the periodic signal;
e) converting the jitter verus time vector array to a phase error versus time vector array using an estimate of the average frequency of the periodic signal;
f) applying a time to frequency transform to the phase error versus time vector array to generate a phase error magnitude versus frequency vector array; and
g) obtaining a phase noise spectral density vector array by normalizing the random phase error magnitude component of the phase error magnitude versus frequency vector array to a one hertz bandwidth.

5. The method of estimating phase noise spectral density in a periodic signal as recited in claim 4 wherein the generating of the estimated reference crossing times vector array step further comprises the step of estimating rising edge reference crossing times of the periodic signal in the waveform record.

6. The method of estimating phase noise spectral density in a periodic signal as recited in claim 4 wherein the generating of the estimated reference crossing times vector array step further comprises the step of estimating falling edge reference crossing times of the periodic signal in the waveform record.

7. The method of estimating phase noise spectral density in a periodic signal as recited in claim 4 wherein the generating of the estimated reference crossing times vector array step further comprises the steps of:

a) concurrently generating a vector array of estimated rising reference crossing times of the periodic signal in the waveform record using interpolation and a vector array of estimated falling reference crossing times of the periodic signal in the waveform record using interpolation; and
b) generating a vector array of estimated pulse width deviation times by comparing the estimated rising reference crossing times vector array to the estimated falling reference crossing times vector array.

8. The method of estimating phase noise spectral density in a periodic signal as recited in claim 4 wherein the generating of the estimated reference crossing times vector array step further comprises the step of interpolating between at least a first data sample above the reference crossing and at least a first data sample below the reference crossing.

9. The method of estimating phase noise spectral density in a periodic signal as recited in claim 8 wherein interpolating step further comprises the step of linearly interpolating between the first data sample above the reference crossing and the first data sample below the reference crossing.

10. The method of estimating phase noise spectral density in a periodic signal as recited in claim 8 wherein the interpolating step further comprises the step of generating a higher order interpolator using multiple digital data samples above and below the reference crossing.

11. The method of estimating phase noise spectral density in a periodic signal as recited in claim 10 wherein the generating a higher order interpolator step further comprises the step of generating a windowed sin(x)/x function.

12. The method of estimating phase noise spectral density in a periodic signal as recited in claim 4 wherein the calculating the estimated periodic signal frequency further comprising the step of interpolating an average slope from the number of reference crossing times and the sum of the reference crossing times.

13. The method of estimating phase noise spectral density in a periodic signal as recited in claim 12 wherein the interpolating step further comprises the steps of:

 a) calculating a best fit linear curve to the respective number of reference crossing times and the corresponding reference crossing times; and
 b) estimating the periodic signal frequency from the slope of the fitted line.

14. The method of estimating phase noise spectral density in a periodic signal as recited in claim 4 further comprising the steps of:

 a) using a filter function to define a frequency band in the phase noise spectral density vector array; and
 b) integrating the filtered phase noise values in the phase noise spectral density vector array over the defined frequency band to obtain a jitter RMS value within the define frequency band.

15. The method of estimating phase noise spectral density in a periodic signal as recited in claim 4 wherein the converting step further comprises the step of multiply the jitter versus time vector array by average frequency of the periodic signal in radians per second.

16. A method of estimating jitter in a periodic signal acquired in a digitally sampled waveform record comprising the steps of:

 a) generating a vector array of estimated reference crossing times of the periodic signal in the waveform record using interpolation;
 b) calculating an estimated periodic signal frequency based on a selected number of reference crossings in the estimated reference crossing times vector array and associated time positions of the waveform samples from the first selected reference crossing to the last selected reference crossing in the waveform record;
 c) generating a vector array of uniformly spaced ideal reference crossing times based on the estimated periodic signal frequency; and
 d) generating a uniformly spaced jitter versus time vector array by determining the difference between the ideal reference crossing times and the corresponding estimated reference crossing times of the periodic signal;

17. The method of estimating jitter in a periodic signal as recited in claim 16 wherein the generating of the estimated reference crossing times vector array step further comprises the step of estimating rising edge reference crossing times of the periodic signal in the waveform record.

18. The method of estimating jitter in a periodic signal as recited in claim 16 wherein the generating of the estimated reference crossing times vector array step further comprises the step of estimating falling edge reference crossing times of the periodic signal in the waveform record.

19. The method of estimating jitter in a periodic signal as recited in claim 16 wherein the generating of the estimated reference crossing times vector array step further comprises the steps of:

 a) concurrently generating a vector array of estimated rising reference crossing times of the periodic signal in the waveform record using interpolation and a vector array of estimated falling reference crossing times of the periodic signal in the waveform record using interpolation; and
 b) generating a vector array of estimated pulse width deviation times by comparing the estimated rising reference crossing times vector array to the estimated falling reference crossing times vector array.

20. The method of estimating jitter in a periodic signal as recited in claim 16 wherein the generating of the estimated reference crossing times vector array step further comprises the step of interpolating between at least a first data sample above the reference crossing and at least a first data sample below the reference crossing.

21. The method of estimating jitter in a periodic signal as recited in claim 20 wherein interpolating step further comprises the step of linearly interpolating between the first data sample above the reference crossing and the first data sample below the reference crossing.

22. The method of estimating jitter in a periodic signal as recited in claim 20 wherein the interpolating step further comprises the step of generating a higher order interpolator using multiple digital data samples above and below the reference crossing.

23. The method of estimating jitter in a periodic signal as recited in claim 22 wherein the generating a higher order interpolator step further comprises the step of generating a windowed sin(x)/x function.

24. The method of estimating jitter in a periodic signal as recited in claim 20 wherein the calculating the estimated periodic signal frequency further comprising the step of interpolating an average slope from the number of reference crossing times and the sum of the reference crossing times.

25. The method of estimating jitter in a periodic signal as recited in claim 24 wherein the interpolating step further comprises the steps of:

   a) calculating a best fit linear curve to the respective number of reference crossing times and the corresponding reference crossing times; and
   b) estimating the periodic signal frequency from the slope of the fitted line.

EP 1 118 866 A1

FIGURE 1

11

FIGURE 2

FIGURE 3

FIGURE 4

FIGURE 5

TIME

Jitter

$\Delta t$

$t_i^{ideal} - t^{real}$

$t_1^{ideal}$

$t_n^{ideal}$

FIGURE 6

WAVEFORM RECORD

| | |
|---|---|
| GENERATE ESTIMATED REF CROSSING ARRAY {t_REF_REAL} FROM THE WAVEFORM RECORD USING INTERPOLATION | 90 |
| CALCULATE ESTIMATED PERIODIC SIGNAL FREQUENCY USING {t_REF_REAL} | 92 |
| GENERATE IDEAL REF CROSSING VECTOR ARRAY {t_REF_IDEAL} USING ESTIMATED PERIODIC SIGNAL FREQUENCY | 94 |
| GENERATE UNIFORMLY SPACED JITTER VERSUS TIME VECTOR ARRAY {JITTER_TIME} FROM THE DIFFERENCE BETWEEN {t_REF_IDEAL}-{t_REF_REAL} | 96 |
| CONVERT {JITTER_TIME} VECTOR ARRAY TO PHASE ERROR VERSUS TIME VECTOR ARRAY {PHASE_ERROR_TIME} IN RADIANS | 98 |
| GENERATE PHASE ERROR MAGNITUDE VERSUS FREQUENCY VECTOR ARRAY {PHASE_ERROR_FREQ} BY APPLYING A TIME TO FREQUENCY TRANSFER FUNCTION TO {PHASE_ERROR_TIME} | 100 |
| NORMALIZE {PHASE_ERROR_FREQ} VECTOR ARRAY TO 1Hz TO OBTAIN PHASE NOISE SPECTRAL DENSITY VECTOR ARRAY {PHASE_NOISE} | 102 |
| DEFINE FREQUENCY BAND WITHIN {PHASE_NOISE} | 104 |
| INTEGRATE PHASE NOISE SPECTRAL VALUES WITHIN FREQUENCY BAND TO OBTAIN JITTER RMS IN FREQUENCY BAND | 106 |

END

FIG.7

**European Patent Office**

## EUROPEAN SEARCH REPORT

Application Number

EP 01 30 0348

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 757 652 A (BLAZO STEPHEN F ET AL) 26 May 1998 (1998-05-26) * claims 1,7 * | 1,4,16 | G01R29/26 G01R13/34 |
| A | GB 2 158 254 A (HEKIMIAN NORRIS C) 6 November 1985 (1985-11-06) * claim 1 * | 1,4,16 | |
| A | EP 0 262 860 A (AMERICAN TELEPHONE & TELEGRAPH) 6 April 1988 (1988-04-06) * the whole document * | 1,4,16 | |

| | TECHNICAL FIELDS SEARCHED (Int.Cl.7) |
|---|---|
| | G01R |

The present search report has been drawn up for all claims

| Place of search | Date of completion of the search | Examiner |
|---|---|---|
| THE HAGUE | 24 April 2001 | Six, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**EP 1 118 866 A1**

### ANNEX TO THE EUROPEAN SEARCH REPORT
### ON EUROPEAN PATENT APPLICATION NO.

EP 01 30 0348

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2001

| Patent document cited in search report | | Publication date | Patent family member(s) | | Publication date |
|---|---|---|---|---|---|
| US 5757652 | A | 26-05-1998 | NONE | | |
| GB 2158254 | A | 06-11-1985 | DE 3514650 A<br>IT 1181880 B<br>JP 61016654 A | | 31-10-1985<br>30-09-1987<br>24-01-1986 |
| EP 0262860 | A | 06-04-1988 | JP 63103979 A | | 09-05-1988 |

EPO FORM P0459